# EUROPEAN PATENT APPLICATION

(11) **EP 4 751 869 A1**
(43) Date of publication of application: **03.06.2026**
(21) Application number: 25218236.5
(22) Date of filing: 25.11.2025
(51) Int. Cl.: B26D 7/14, B26F 1/44, B26F 1/02, B26F 1/12, B26F 1/14

(54) **ELECTRODE PLATE NOTCHING APPARATUS AND METHOD OF NOTCHING ELECTRODE PLATE**

(30) Priority: 27.11.2024 KR 20240171605
(71) Applicant: SAMSUNG SDI CO., LTD., Yongin-si, Gyeonggi-do 17084 (KR)
(72) Inventor: Hwang, Hyun Bin, Suwon-si, Gyeonggi-do 16678 (KR)
(74) Representative: Meissner Bolte Partnerschaft mbB

(57) **Abstract**

The present invention relates to an electrode plate notching apparatus and a method of notching an electrode, and an object thereof is to prevent generation of threads or burrs in a notching process. An electrode plate notching apparatus (1) according to embodiments includes a lower body (100) which supports an electrode plate (10) transferred in a first direction, a die (300) installed on the lower body (100) to face a non-coating portion of the electrode plate (10) and including a punch hole (400), an upper body (200) installed above the lower body (100) to be movable upwardly and downwardly, a punch (500) installed on the upper body (200) to ascend and descend in conjunction with ascent and descent of the upper body (200) and inserted into the punch hole (400) as the upper body (200) descends, and a tension application member (600) which applies tension to the electrode plate (10) in a second direction intersecting the first direction before the punch (500) is inserted into the punch hole (400).

## Description

### FIELD

The present invention relates to an electrode plate notching apparatus and a method of notching an electrode plate.

### BACKGROUND

Secondary batteries are batteries capable of being charged and discharged unlike primary batteries that cannot be charged. Low-capacity secondary batteries are used in small portable electronic devices such as smartphones, feature phones, notebook computers, digital cameras, and camcorders, and large-capacity secondary batteries are widely used as power sources for driving motors and batteries for power storage in hybrid vehicles, electric vehicles, and the like. Such a secondary battery includes an electrode including a positive electrode and/or a negative electrode, an electrode assembly including the electrode, a case for accommodating the electrode assembly, an electrode terminal connected to the electrode assembly, and the like.

With the development of this technology, high-capacity batteries are required. Accordingly, a plurality of batteries may be electrically connected and used. For example, batteries may be applied to an electronic device in the form of a battery module including a plurality of batteries (hereinafter, battery cells) and/or a battery pack including a plurality of battery modules. According to an embodiment, a battery pack may be formed of a plurality of battery cells. In this case, the electronic device is one that requires high-output power and/or a high-capacity and includes, for example, an electric vehicle or the like.

The herein-described information described in the background technology of this invention is only for facilitating understanding of the background of the present invention and therefore may also include information that does not constitute the related art.

### SUMMARY

The present invention is directed to providing an electrode plate notching apparatus capable of suppressing or preventing generation of threads or burrs when a non-coating portion is cut, and a method of notching an electrode plate.

However, technical objects to be achieved through the present invention are not limited to the herein-described objects, and other objects which are not described herein will be clearly understood by those skilled in the art from the following description of the present invention.

In accordance with the present invention, there is provided an electrode plate notching apparatus including a lower body which supports an electrode plate transferred in a first direction, a die installed on the lower body to face a non-coating portion of the electrode plate and including a punch hole, an upper body installed above the lower body to be movable upwardly and downwardly, a punch installed on the upper body to ascend and descend in conjunction with ascent and descent of the upper body and inserted into the punch hole as the upper body descends, and a tension application member which applies tension to the electrode plate in a second direction intersecting the first direction before the punch is inserted into the punch hole.

In embodiments, the tension application member may be installed on the upper body to ascend and descend in conjunction with the ascent and the descent of the upper body.

In embodiments, the tension application member may be installed further outwardly than the punch in the second direction.

In embodiments, the tension application member may be installed on the upper body to protrude downwardly further than a lower surface of the punch.

In embodiments, the tension application member may be formed such that a lower end portion of the tension application member moves outwardly in the second direction when a force is applied to the tension application member downwardly as the upper body descends.

In embodiments, the tension application member may include a support of which an upper end is fixed to the upper body, a sliding portion of which an upper end surface is disposed in surface contact with a lower end surface of the support such that the sliding portion moves toward an outer side of the support in the second direction when the support descends after a lower end of the sliding portion is in contact with the electrode plate, and an elastic connection member of which an upper end is fixed to the support, a lower end is fixed to the sliding portion to connect the support to the sliding portion, and a length is increasable or decreasable.

In embodiments, a contact surface of the upper end surface of the sliding portion and the lower end surface of the support may be inclined upwardly from a center toward an outside of a lower surface of the upper body.

In embodiments, the elastic connection member may be installed to allow the support and the sliding portion to be connected in a vertically aligned state when the elastic connection member is contracted and allow the sliding portion and the support to be connected in a state in which the sliding portion moves toward the outer side of the support in the second direction when the elastic connection member is elongated.

In embodiments, a contact member may be provided on a lower end of the tension application member.

In embodiments, the contact member may be formed of rubber.

In accordance with the present invention, there is provided an electrode plate notching apparatus including a lower body which supports an electrode plate which is transferred in a first direction and includes non-coating portions at both edges in a second direction intersecting the first direction, a pair of dies installed on the lower body to be spaced apart from each other in the second direction to face the non-coating portions and each including a punch hole, an upper body installed above the lower body to be moveable upwardly and downwardly, a pair of punches installed on the upper body to be spaced apart from each other in the second direction to ascend and descend in conjunction with ascent and descent of the upper body and inserted into the pair of punch holes as the upper body descends, and a pair of tension application members installed on the upper body to be spaced apart from each other in the second direction to ascend and descend in conjunction with the ascent and the descent of the upper body and apply tension to the electrode plate in the second direction before the punches are inserted into the punch holes.

In embodiments, the tension application member may be installed further outwardly than the punch in the second direction.

In embodiments, the tension application member may be installed on the upper body to protrude downwardly further than a lower surface of the punch.

In embodiments, the tension application member may be formed such that a lower end portion moves outwardly in the second direction when a force is applied to the tension application member downwardly as the upper body descends.

In embodiments, the tension application member may include a support of which an upper end is fixed to the upper body, a sliding portion of which an upper end surface is disposed in surface contact with a lower end surface of the support such that the sliding portion moves toward an outer side of the support in the second direction when the support descends after a lower end of the sliding portion is in contact with the electrode plate, and an elastic connection member of which an upper end is fixed to the support and a lower end is fixed to the sliding portion to connect the support to the sliding portion, and a length is increasable or decreasable.

In embodiments, a contact surface of the upper end surface of the sliding portion and the lower end surface of the support may be inclined upwardly from a center toward an outside of a lower surface of the upper body.

In embodiments, the elastic connection member may be installed to allow the support and the sliding portion to be connected in a vertically aligned state when the elastic connection member is contracted and allow the sliding portion and the support to be connected in a state in which the sliding portion moves toward an outer side of the support in the second direction when the elastic connection member is elongated.

In embodiments, a contact member may be provided on a lower end of the tension application member.

In accordance with aspects of the present invention, there is provided a method of notching an electrode plate, which includes an electrode plate arrangement operation of transferring an electrode plate in a first direction to arrange the electrode plate on an electrode plate notching apparatus, a tension application operation of applying tension to the electrode plate in a second direction intersecting the first direction, and a cutting operation of cutting and removing a portion of a non-coating portion of the electrode plate to which the tension is applied.

In embodiments, the electrode plate notching apparatus may be the herein-described electrode plate notching apparatus.

### BRIEF DESCRIPTION OF THE DRAWINGS

Since the accompanying drawings of the present specification illustrate exemplary embodiments of the present invention and serve to convey the technical spirit of the present invention with the detailed description of the present invention herein, the present invention should not be interpreted in a limited sense with reference to the content in the accompanying drawings;
FIG. 1 is a schematic perspective view illustrating an electrode plate notching apparatus according to embodiments;
FIG. 2 is a schematic cross-sectional perspective view illustrating a portion of the electrode plate notching apparatus of FIG. 1;
FIG. 3 is a cross-sectional view illustrating the electrode plate notching apparatus of FIG. 1;
FIG. 4 is a plan view illustrating the electrode plate notching apparatus of FIG. 1;
FIG. 5 is a plan view illustrating the electrode plate notching apparatus of FIG. 1;
FIG. 6 is a schematic perspective view illustrating one example of a die, a punch hole, and a punch in the electrode plate notching apparatus of FIG. 1;
FIG. 7A is a schematic cross-sectional view illustrating a state of a tension application member that is not yet in contact with an electrode plate;
FIG. 7B is a view illustrating a state of the tension application member in contact with the electrode plate and applying tension to the electrode plate; and
FIGS. 8A to 8D are schematic cross-sectional views illustrating a method of notching an electrode plate according to embodiments.

### DETAILED DESCRIPTION

Hereinafter, exemplary embodiments of the present invention will be described in detail with reference to the accompanying drawings. First, terms and words used in the present specification and claims should not be interpreted as being limited to commonly used meanings or meanings in dictionaries and should be interpreted as having meanings and concepts which are consistent with the technological scope of the present invention based on the principle that the inventors have appropriately defined concepts of the terms in order to describe the present invention in the best way. Therefore, since the embodiments described in this specification and components illustrated in the drawings are only some exemplary embodiments and do not represent the overall technological scope of the present invention, it should be understood that there may be various equivalents or modifications replacing the exemplary embodiments at the time of filing of this application.

In addition, the terms "comprise," "include," "comprising," and/or "including" used in the present specification specify the presence of stated shapes, numbers, steps, operations, members, elements, and/or groups thereof but do not preclude the presence or addition of one or more other shapes, numbers, steps, operations, members, elements, and/or groups thereof.

In addition, in order to facilitate understanding of the present invention, the accompanying drawings are not drawn to actual scale, and the dimensions of some components may be exaggerated. In addition, like reference numerals may be assigned to like elements in different embodiments.

The statement that two comparative objects are "the same" means that the two comparative objects are "substantially the same." Therefore, the term "substantially the same" includes a case in which there is a deviation considered as a low level in the art, for example, a deviation of 5% or less. In addition, the description that some parameters are uniform within a certain region may mean that the parameters are uniform from an average perspective.

Although terms such as "first," "second," or the like may be used for describing various elements, the elements are not limited by these terms. These terms are only used to distinguish one element from another element, and unless otherwise specifically described, a first element may also be a second element.

Throughout the specification, unless specifically described otherwise, each element may be singular or plural.

A case in which a first element is disposed "over (or under)" or "above (or below)" a second element may include a case in which the first element is disposed in contact with an upper (or lower) surface of the second element or a case in which a third element is interposed between the first element and the second element disposed over (or under) the first element.

When a first element is referred to as being "disposed on," connected to," or "coupled to" a second element, although the first element may be directly connected or bonded to the second element, it should be understood that a third element may be interposed therebetween, or the first and second elements may be connected, coupled, or bonded through the third element.

As used in the present specification, the term "and/or" includes any one or more and all combinations of the associated listed items. In addition, when embodiments of the present invention are described, the use of "may" relates to "one or more embodiments of the present invention." Expressions such as "one or more" and "at least one" before a list of elements modify the list of elements as a whole and do not modify the individual elements of the list.

Throughout the specification, unless otherwise specifically described, "A and/or B" means A, B, or A and B. Unless otherwise specifically described, "C to D" means more than or equal to C and less than or equal to D.

When a phrase "at least one of A, B, and C," "at least one of A, B, or C," "at least one selected from the group consisting of A, B, and C," or "at least one selected from A, B, and C" is used to indicate a list of elements A, B and C, the phrase may refer to any suitable combination thereof.

The term "use" may be considered synonymous with the term "utilize." As used in the present specification, the terms "substantially," "about," and words similar thereto are used as terms of approximation rather than terms of degree, and are intended to consider intrinsic variations in measured or calculated values recognized by those skilled in the art.

Although the terms "first," "second," "third," etc., may be used in the present specification to describe various elements, components, regions, layers, and/or sections, these elements, components, regions, layers, and/or sections should not be limited by these terms. These terms are only used to distinguish one element, component, region, layer, or cross section from another element, component, region, layer, or cross section. Accordingly, a first member, component, region, layer, or section could be named a second element, component, region, layer, or section without departing from the teachings of the exemplary embodiments.

Spatially relative terms "beneath," "below," "lower," "above," "upper," etc., may be used to describe relationships between one component or feature and another component(s) or feature(s) illustrated in the drawings. A spatially relative location may be understood to encompass different orientations of devices, which are being used or operated, in addition to orientations illustrated in the drawings. For example, when a device in the drawing is flipped over, an element described as "under" or "below" another element is understood to be "over" or "above" the other element. Accordingly, the term "below" encompasses both "above" and "below."

Terms used in the present specification are used to describe embodiments of the present invention and are not intended to limit the present invention.

In a process of manufacturing a positive electrode or negative electrode of a battery, there is a notching process of manufacturing an electrode tab by removing a portion of an electrode plate. The notching process is performed through a method of removing a portion of a non-coating portion of the electrode plate which is not coated with an electrode active material. The removing of the non-coating portion is performed through a method of using a punching machine, laser, or the like. In the notching process, particularly the notching process using the punching machine, a cut area needs to be removed cleanly to prevent generation of residues such as threads or burrs.

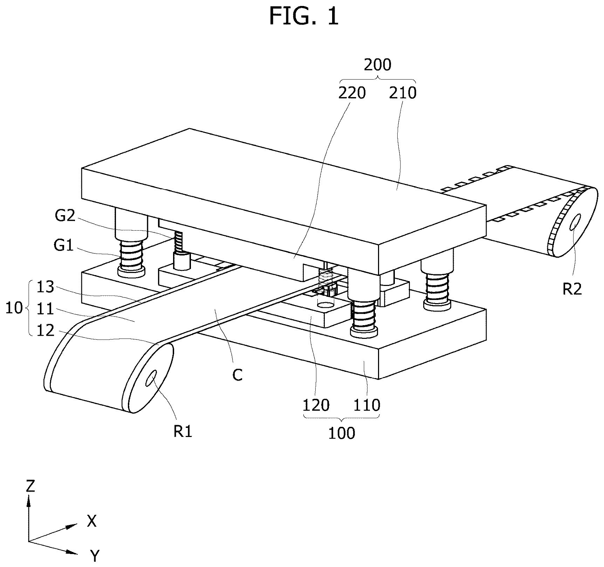

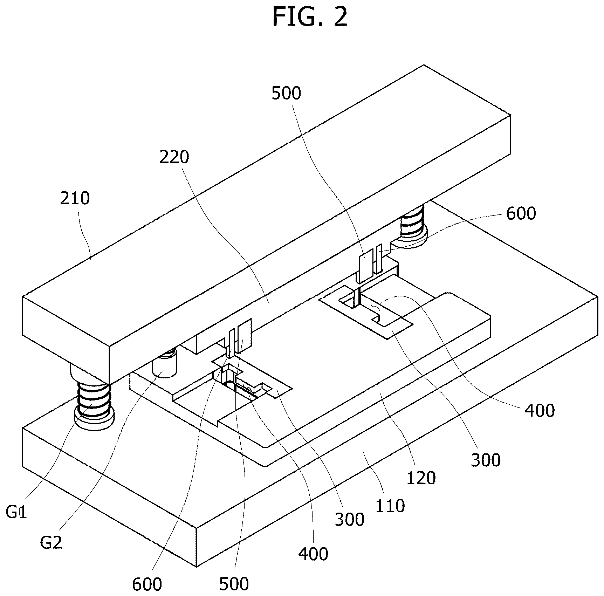

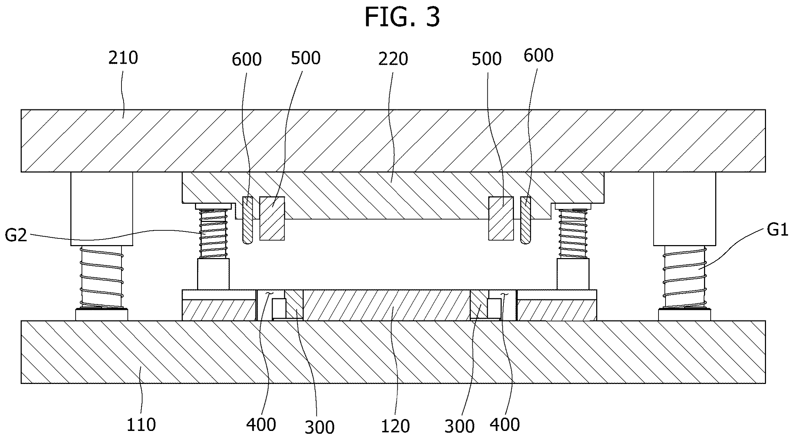

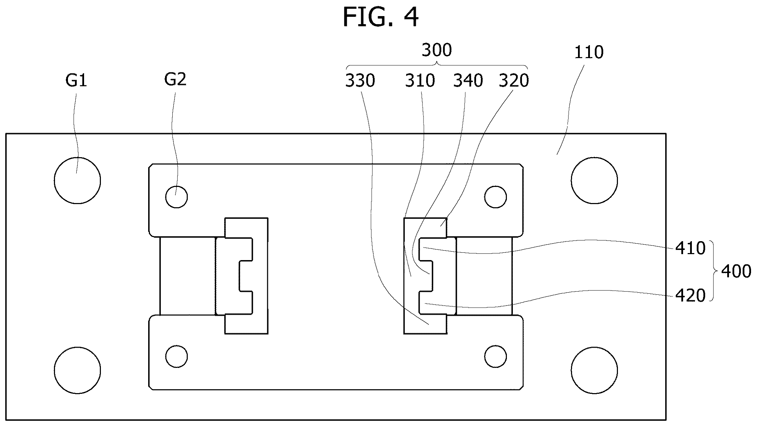

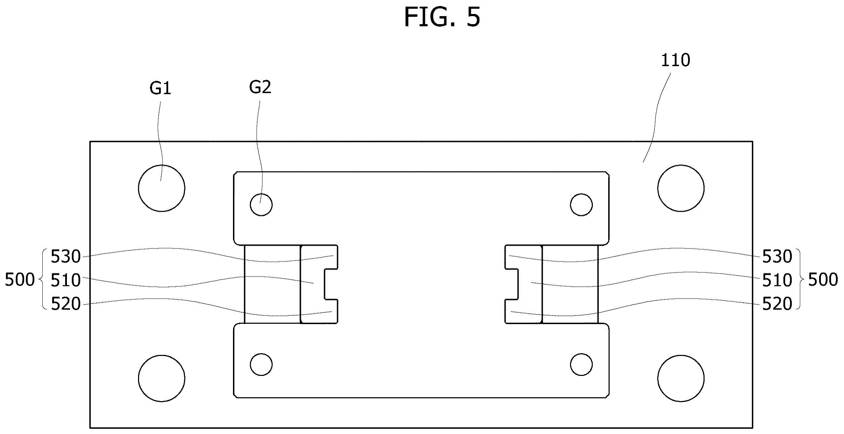

FIG. 1 is a schematic perspective view illustrating an electrode plate notching apparatus according to embodiments, and FIG. 2 is a schematic cross-sectional perspective view illustrating a portion of the electrode plate notching apparatus of FIG. 1. FIG. 3 is a cross-sectional view illustrating the electrode plate notching apparatus of FIG. 1, and FIGS. 4 and 5 are plan views illustrating the electrode plate notching apparatus of FIG. 1.

Referring to FIGS. 1 to 5, an electrode plate notching apparatus 1 includes a lower body 100, an upper body 200, a die 300, a punch hole 400, a punch 500, and a tension application member 600. The electrode plate notching apparatus 1 may be an apparatus which is disposed between a first roller R1, around which an electrode plate 10 is wound, and a second roller R2 around which the electrode plate 10, on which a notching process is performed by the electrode plate notching apparatus 1, is wound again, and removes a portion of a second region 12 and/or a third region 13 corresponding to a non-coating portion of the electrode plate 10.

In this case, the electrode plate 10, to which tension is applied outwardly in a direction parallel to a transfer direction, that is, a first direction (X-axis direction), may be loaded on the electrode plate notching apparatus 1 by the first roller R1 and the second roller R2. In addition, as will be illustrated herein, the electrode plate notching apparatus 1 may remove the portion of the second region 12 and/or the third region 13 even in a state in which outward tension is applied to the electrode plate 10 in a second direction (Y-axis direction) intersecting the first direction, and this will be described in detail.

The lower body 100 may form a lower exterior of the electrode plate notching apparatus 1 and function as a component which supports the entirety of the upper body 200 and the die 300. The lower body 100 may include a first lower body 110 and a second lower body 120. Specific shapes of the first lower body 110 and the second lower body 120 are not limited to the shapes illustrated in FIGS. 1 to 5, and their designs may be changed to any of various shapes.

The first lower body 110 may be formed in a rigid body shape having a substantially quadrangular cross-section. The first lower body 110 may be fixed to a ground surface or separate structure (not shown) through any of various coupling methods such as welding, bolting, and fitting.

The second lower body 120 may be seated on the first lower body 110 and provide a space in which the die 300, which will be described herein, is mounted. A cross-sectional area of the second lower body 120 may be smaller than a cross-sectional area of the first lower body 110. The second lower body 120 may be fixed to the first lower body 110 through any of various coupling methods such as welding, bolting, and fitting. An upper surface of the second lower body 120 may have a flat shape parallel to an XY plane based on FIG. 1.

The lower body 100 may support the electrode plate 10 transferred in the first direction. In this case, based on FIG. 1, the first direction may be a direction from the first roller R1 toward the second roller R2, that is, a direction parallel to an X-axis.

The electrode plate 10 may have a thin foil form. The electrode plate 10 may be formed of a conductive material such as copper, a copper alloy, nickel, a nickel alloy, aluminum, or an aluminum alloy. The electrode plate 10 may continuously extend in the first direction which is a longitudinal direction. A lower surface of the electrode plate 10 may be disposed to face the upper surface of the second lower body 120. The lower surface of the electrode plate 10 may be in direct contact with the upper surface of the second lower body 120 or disposed to be spaced a predetermined distance from the upper surface of the second lower body 120.

The electrode plate 10 may be transferred in the first direction while both end portions of the electrode plate 10 are wound around and unwound from the transfer rollers R1 and R2. In this case, the electrode plate 10 may be transferred a set distance in the first direction step by step. For example, the electrode plate 10 may repeat an action of being transferred the set distance in the first direction and then stopped for a set time. The set distance and the set time may be properly determined in consideration of a configuration of the electrode plate notching apparatus 1, the number of electrode tabs manufactured through one notching process, a size and shape of the electrode tab, and the like.

The electrode plate 10 may include a first region 11, a second region 12, and a third region 13.

In the entire region of the electrode plate 10, the first region 11 may be a region in which an active material C is formed. As an example, in the entire region of the electrode plate 10, the first region 11 may be a central region coated with the active material C. The active material C may be formed on one surface or both surfaces of the electrode plate 10.

The active material C may be a positive electrode active material capable of reversible intercalation and deintercalation for lithium or a negative electrode active material capable of reversible intercalation and deintercalation for lithium ions. The positive electrode active material may include one or more compound oxides of a metal selected from the group consisting of cobalt, manganese, nickel, and a combination thereof and lithium. The negative electrode active material may include crystalline carbon, amorphous carbon, or a combination thereof.

In the entire region of the electrode plate 10, the second region 12 may be a region which is not coated with the active material C. As an example, in the entire region of the electrode plate 10, the second region 12 may be one end region of the electrode plate 10 protruding from the first region 11 in a direction parallel to the second direction (Y-axis direction). The second direction may be a direction intersecting the first direction, and as an example, a direction perpendicular to the first direction and a vertical direction, that is, a direction from the first region 11 toward the second region 12 in a direction parallel to a Y-axis based on FIG. 1.

The electrode plate 10 may further include a third region 13. The third region 13 may be a region excluding the second region 12 in the region which is not coated with the active material C in the electrode plate 10. As an example, in the entire region of the electrode plate 10, the third region 13 may be the other end region of the electrode plate 10 located at a side opposite to the second region 12. The second region 12 and the third region 13 may be disposed to be spaced apart from each other in the direction parallel to the second direction.

Hereinafter, an example of the electrode plate 10 including all the first region 11, the second region 12, and the third region 13 will be described. In addition, an example in which the same numbers and shapes of the electrode tabs are formed in the second region 12 and the third region 13 will be described. However, the electrode plate 10 is not limited thereto, and the electrode plate 10 may include only the first region 11 and the second region 12. In addition, even when the electrode plate 10 includes the third region 13, the numbers and the shapes of the electrode tabs formed in the second region 12 and the third region 13 may be different.

The upper body 200 may form an upper exterior of the electrode plate notching apparatus 1 and function as a component which supports the punch 500 and the tension application member 600 which will be described herein. The upper body 200 may be installed on the lower body 100 to be movable upwardly and downwardly.

The upper body 200 may descend after the electrode plate 10 is transferred the set distance in the first direction. Accordingly, the upper body 200 may allow the die 300, the punch hole 400, the punch 500, and the tension application member 600 to perform a cutting action on the second region 12 and/or the third region 13 at a time point at which the transfer of the electrode plate 10 is stopped.

The upper body 200 may include a first upper body 210 and a second upper body 220. Specific shapes of the first upper body 210 and the second upper body 220 are not limited to the shapes illustrated in FIGS. 1 to 5, and their designs may be variously changed to any of various shapes.

The first upper body 210 may be formed in a rigid body shape having a substantially quadrangular cross-section. The first upper body 210 may be disposed above the lower body 100. The first upper body 210 may be connected to a separate power apparatus (not shown) such as a press or cylinder and ascend and descend in the vertical direction using a driving force generated by the power apparatus.

A first guide post G1 which guides ascent and descent of the first upper body 210 may be installed between the first lower body 110 and the first upper body 210. The first guide post G1 may have a column shape of which a longitudinal direction extends in the vertical direction. Upper and lower end portions of the first guide post G1 may be connected to the first lower body 110 and the first upper body 210, respectively. The first guide post G1 may have a telescopic structure of which a length is changeable in conjunction with the ascent and descent of the first upper body 210. The first guide post G1 may be provided to be vertically separable when the first upper body 210 ascends a predetermined distance. A spring capable of returning the first upper body 210 to its initial location when an external force applied to the first upper body 210 is removed may be installed on the first guide post G1.

The first guide post G1 may be provided as a plurality of first guide posts G1. The plurality of first guide posts G1 may be disposed at corners of each of the first lower body 110 and the first upper body 210.

The second upper body 220 may be disposed under the first upper body 210 to face the second lower body 120. A cross-sectional area of the second upper body 220 may be smaller than a cross-sectional area of the first upper body 210. The second upper body 220 may be fixed to the first upper body 210 through any of various coupling methods such as welding, bolting, and fitting. The second upper body 220 may ascend and descend with the first upper body 210 when the first upper body 210 ascends and descends. A lower surface of the second upper body 220 may have a flat shape parallel to the XY plane based on FIG. 1.

A second guide post G2 which guides ascent and descent of the second upper body 220 may be installed between the second lower body 120 and the second upper body 220. The second guide post G2 may be a column shape of which a longitudinal direction extends in the vertical direction. Upper and lower end portions of the second guide post G2 may be connected to the second lower body 120 and the second upper body 220, respectively. The second guide post G2 may have a telescopic structure of which a length is changeable in conjunction with the ascent and descent of the second upper body 220. The second guide post G2 may be provided to be vertically separable when the second upper body 220 ascends a predetermined distance. A spring capable of returning the second upper body 220 to its initial location when an external force applied to the second upper body 220 is removed may be installed on the second guide post G2.

The second guide post G2 may be provided as a plurality of second guide posts G2. The plurality of second guide posts G2 may be disposed at corners of each of the second lower body 120 and the second upper body 220.

The die 300 may installed on the lower body 100 to face a non-coating portion of the electrode plate 10, for example, one region of the die 300 may be disposed to face the second region 12. In addition, another region of the die 300 may be disposed to face the third region 13. The die 300 may function as a component which determines a processing shape of each of the second region 12 and the third region 13 with the punch hole 400 which will be described herein.

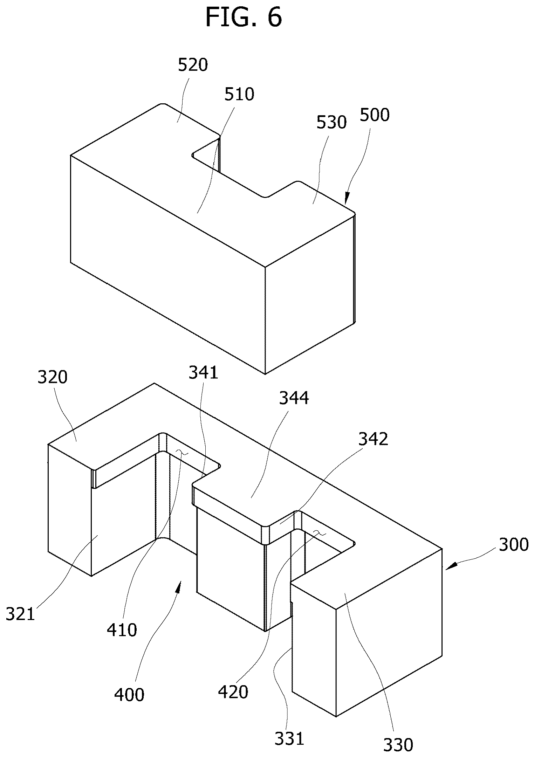

FIG. 6 is a schematic perspective view illustrating one example of the die 300, the punch hole 400, and the punch 500 in the electrode plate notching apparatus 1 of FIG. 1. Dies 300 (e.g., a pair of dies 300), punch holes 400 (e.g., a pair of punch holes 400), and punches 500 (e.g., a pair of punches 500) each having the same shape and structure may be symmetrically disposed in the second direction or with respect to the first direction at both sides of the electrode plate notching apparatus 1 in the second direction. For example, the pair of dies 300 may be installed on the lower body 100 to be spaced apart from each other in the second direction to face the non-coating portions (i.e., the second region 12 and/or the third region 13) of the electrode plate 10, the pair of dies 300 may each include a punch hole 400 (i.e., the pair of punch holes 400 may be included in the pair of dies 300, respectively), and the pair of punches 500 may be installed on the upper body 200 to be spaced apart from each other in the second direction. However, the present invention is not limited thereto, and dies, punch holes and punches each having different shapes and structures may be disposed at both sides of the electrode plate notching apparatus 1 in the second direction.

Referring to FIGS. 1 to 6, the die 300 may include a die body 310, a first extension 320, a second extension 330, and a tab support 340. However, a shape and a structure of the die 300 illustrated in FIG. 6 are only exemplary and may be variously changed according to a shape or the number of tabs to be manufactured.

The die body 310 may be fixed to the lower body 100 and support the entirety of the first extension 320, the second extension 330, and the tab support 340 which will be described herein. The die body 310 may be disposed in the second lower body 120. An upper surface of the die body 310 may be exposed to an external space of the second lower body 120 through the upper surface of the second lower body 120. The upper surface of the die body 310 may be located coplanar with the upper surface of the second lower body 120. A longitudinal direction of the die body 310 may be parallel to the first direction. The upper surface of the die body 310 may be disposed to face the first region 11 of the electrode plate 10.

The first extension 320 and the second extension 330 may extend in the second direction from both side ends of the die body 310 in the longitudinal direction thereof (or the first direction). Lengths of the first extension 320 of the second extension 330 parallel to the second direction may be the same. The first extension 320 and the second extension 330 may be sequentially disposed in the first direction. That is, the second extension 330 may be disposed at a location spaced a predetermined distance from the first extension 320 in the first direction. The first extension 320 and the second extension 330 may be disposed in the second lower body 120. Upper surfaces of the first extension 320 and the second extension 330 may be exposed to an external space of the second lower body 120 through the upper surface of the second lower body 120. The upper surfaces of the first extension 320 and the second extension 330 may be located coplanar with the upper surface of the die body 310. The upper surfaces of the first extension 320 and the second extension 330 may be disposed to face the second region 12 or the third region 13 of the electrode plate 10.

The first extension 320 and the second extension 330 may include a first surface 321 or a second surface 331, respectively. In the entire perimetric surface of the first extension 320, the first surface 321 may be a surface facing the second extension 330. In the entire perimetric surface of the second extension 330, the second surface 331 may be a surface facing the first surface 321 of the first extension 320. The second surface 331 may be spaced a predetermined distance from the first surface 321 in the first direction. The first surface 321 and the second surface 331 may be disposed in parallel to face each other.

The tab support 340 may be disposed between the first extension 320 and the second extension 330. The tab support 340 may function as a component which determines a shape of the electrode tab formed in the second region 12 or the third region 13 of the electrode plate 10 when the punch 500 operates. Although one tab support 340 is illustrated in FIG. 6, two or more tab supports 340 may be disposed between the first extension 320 and the second extension 330. In this case, shapes or sizes of the plurality of the tab supports 340 are not necessarily the same and may be different.

The tab support 340 may extend from the die body 310 in the second direction. A length of the tab support 340 parallel to the second direction may be smaller than the length of each of the first extension 320 and the second extension 330 parallel to the second direction. However, the present invention is not limited thereto, and the length of the tab support 340 parallel to the second direction may be the same as the length of each of the first extension 320 and the second extension 330 in the second direction.

The tab support 340 may include a third surface 341 and a fourth surface 342. In the entire perimetric surface of the tab support 340, the third surface 341 may be a surface facing the first surface 321. In the entire perimetric surface of the tab support 340, the fourth surface 342 may be a surface facing the second surface 331. The third surface 341 may be spaced a predetermined distance from the first surface 321 in the first direction and disposed to face the first surface 321 in parallel. The fourth surface 342 may be spaced a predetermined distance from the second surface 331 in the first direction and disposed to face the second surface 331 in parallel.

The punch hole 400 may be formed to pass through the die 300 and function as a component which determines a region cut by the punch 500 in the second region 12 or the third region 13 of the electrode plate 10. The punch hole 400 may include a first punch hole 410 and a second punch hole 420.

The first punch hole 410 and the second punch hole 420 may be formed in groove shapes formed to be recessed in an outer side surface of the die body 310 in the second direction. A longitudinal direction of each of the first punch hole 410 and the second punch hole 420 may be parallel to the second direction. An upper end portion and a lower end portion of each of the first punch hole 410 and the second punch hole 420 may pass through the upper surface and a lower surface of the die body 310, respectively. The first punch hole 410 and the second punch hole 420 may be sequentially disposed in the first direction.

The first punch hole 410 may be disposed between the first extension 320 and the tab support 340. One surface of the first punch hole 410 facing the first extension 320 may be in contact with the first surface 321 of the first extension 320. In this case, one surface of the first punch hole 410 being in contact with the first surface 321 of the first extension 320 may mean that one surface of the first punch hole 410 and the first surface 321 of the first extension 320 are located coplanar with each other. The other surface of the first punch hole 410 facing the tab support 340 may be in contact with the third surface 341 of the tab support 340. In this case, the other surface of the first punch hole 410 being in contact with the third surface 341 of the tab support 340 may mean that the other surface of the first punch hole 410 and the third surface 341 of the tab support 340 are located coplanar with each other.

The second punch hole 420 may be disposed between the second extension 330 and the tab support 340. One surface of the second punch hole 420 facing the second extension 330 may be in contact with the second surface 331 of the second extension 330. In this case, the second punch hole 420 being in contact with the second surface 331 of the second extension 330 may mean that one surface of the second punch hole 420 and the second surface 331 of the second extension 330 are located coplanar with each other. The other surface of the second punch hole 420 facing the tab support 340 may be in contact with the fourth surface 342 of the tab support 340. In this case, the other surface of the second punch hole 420 being contact with the fourth surface 342 of the tab support 340 may mean that the other surface of the second punch hole 420 and the fourth surface 342 of the tab support 340 are located coplanar with each other.

The punch 500 may be installed on the upper body 200 to ascend and descend with the upper body 200 (or in conjunction with ascent and descent of the upper body 200). As the upper body 200 descends, the punch 500 may be inserted into the punch hole 400 and cut the second region 12 or the third region 13 to form the electrode tab on the electrode plate 10.

The punch 500 may include a punch body 510, a first punch 520, and a second punch 530.

The punch body 510 may be fixed to the upper body 200 and support both the first punch 520 and the second punch 530 which will be described herein. The punch body 510 may be fixed to the lower surface of the second upper body 220 through any of various coupling methods such as welding, bolting, and fitting. A longitudinal direction of the punch body 510 may be parallel to the first direction. A lower surface of the punch body 510 may be disposed to face a space between the first extension 320 and the second extension 330. When the upper body 200 descends, the punch body 510 may be inserted into the space between the first extension 320 and the second extension 330. Accordingly, a length of the punch body 510 may correspond to a distance between the first surface 321 and the second surface 331 or be smaller than the distance between the first surface 321 and the second surface 331.

The first punch 520 and the second punch 530 may protrude from the punch body 510 in the second direction. The first punch 520 and the second punch 530 may be formed to have shapes and locations to be insertable into the first punch hole 410 and the second punch hole 420, respectively, when the upper body 200 descends. That is, cross-sectional shapes of the first punch 520 and the second punch 530 may be the same as cross-sectional shapes of the first punch hole 410 and the second punch hole 420, respectively.

The electrode plate notching apparatus 1 according to the present embodiment may further include the tension application member 600. The tension application member 600 may be a member for applying tension to the electrode plate 10 in the direction parallel to the second direction (e.g., applying tension to the electrode plate 10 in the second direction before the punch 500 is inserted into the punch hole 400). To this end, the electrode plate notching apparatus 1 may include two or more (e.g., a pair of) tension application members 600 disposed to be spaced apart from each other in the second direction. The tension application member 600 (or each of the pair of tension application members 600) may be installed further outwardly than the punch 500 (or corresponding one of the pair of punches 500) in the second direction. In addition, two or more tension application members 600 disposed to be spaced apart from each other in the second direction may pull the second region 12 and the third region 13 which are both side end portions of the electrode plate 10 outwardly in a width direction of the electrode plate 10, that is, a direction intersecting the transfer direction of the electrode plate 10.

The tension application member 600 may be configured to apply tension to the electrode plate 10 in the second direction at least when the punch 500 cuts the second region 12 and/or the third region 13. Accordingly, in a state in which the tension is applied to the electrode plate 10 in the width direction, the punch 500 may cut the second region 12 and/or the third region 13. That is, in a state in which the electrode plate 10 is tightly pulled in the width direction (second direction), the punch 500 may cut the second region 12 and/or the third region 13. Accordingly, generation of threads or burrs at a cut surface (particularly, a cut surface in the direction parallel to the first direction) of the second region 12 and/or the third region 13 can be suppressed or prevented

According to embodiments, the tension application member 600 may be installed on the upper body 200 and configured to ascend and descend with the upper body 200 (or in conjunction with ascent and descent of the upper body 200). That is, the tension application member 600 may be configured to descend with the punch 500 to apply tension to the electrode plate 10 in the second direction as the upper body 200 descends. For example, the tension application member 600 (or each of the pair of tension application members 60) may be configured such that a lower end portion thereof moves outwardly in the second direction when a force is applied to the tension application member 600 (or the pair of tension application members 600) downwardly as the upper body 200 descends. Accordingly, a timing (hereinafter, first timing) at which the punch 500 descends and comes into contact with the electrode plate 10 in order to cut the second region 12 and/or the third region 13 and a timing (hereinafter, second timing) at which the tension application member 600 descends and starts to apply tension to the electrode plate 10 in order to apply the tension to the electrode plate 10 may be related to each other.

More specifically, the tension application member 600 may be formed such that the second timing is slightly earlier than the first timing. That is, the tension application member 600 may be formed such that a timing at which the tension application member 600 descending with the upper body 200 starts to come into contact with the electrode plate 10, that is, the second timing, is slightly earlier than the first timing at which the punch 500, which descends with the upper body 200, cuts the second region 12 and/or the third region 13. As an example, the tension application member 600 may be installed on the upper body 200 such that the tension application member 600 (or each of the pair of tension application members 600) is further outwardly than the punch 500 (or corresponding one of the pair of punches 500) in the second direction, for example, a lower end surface of the tension application member 600 (or each of the pair of tension application members 600) is closer to an upper surface of the die 300 (or corresponding one of the pair of dies 300) than a lower surface of the punch 500 (or corresponding one of the pair of punches 500). That is, a length of the tension application member 600 may be greater than a height (a size in a Z-axis direction which is the third direction) of the punch 500.

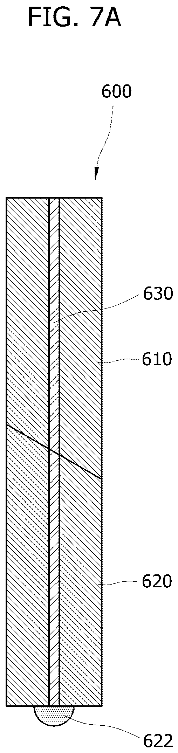

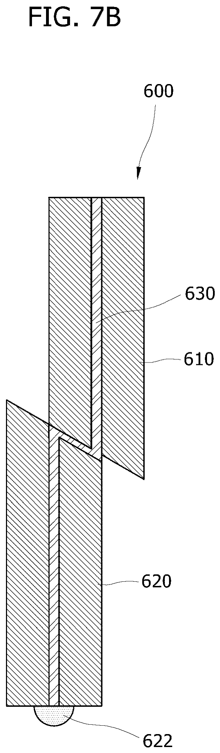

FIGS. 7A and 7B are schematic cross-sectional views illustrating a structure of the tension application member 600, wherein FIG. 7A shows a state of the tension application member 600 that is not yet in contact with the electrode plate 10, and FIG. 7B shows a state of the tension application member 600 in contact with the electrode plate 10 and applying tension to the electrode plate 10. Referring to FIGS. 7A and 7B, the tension application member 600 may include a support 610, a sliding portion 620, and an elastic connection member 630.

The support 610 may be fixed to the upper body 200. For example, the support 610 may be fixed to the lower surface of the second upper body 220 through any of various coupling methods such as welding, bolting, and fitting. The support 610 may have a column shape of which a longitudinal direction extends in the vertical direction. An upper end portion of the support 610 may be connected to the lower surface of the second upper body 220. An upper end surface of the support 610 may be parallel to the lower surface of the second upper body 220.

The support 610 (or the upper end of the support 610) may be fixed to the upper body 200 (e.g., fixed to the second upper body 220 further outwardly than the punch 500 in the second direction) (see FIGS. 2 and 3, and the like). Accordingly, as the upper body 200 descends, the tension application member 600 may come into contact with the electrode plate 10, that is, an outside portion of the second region 12 and the third region 13 further outwardly than the portion of the second region 12 and/or third region 13 which is cut by the punch 500. In general, since the portion corresponding to an outside of the portion which becomes the electrode tab in the second region 12 and the third region 13 corresponds to scraps separated from the electrode plate 10 and discarded through a notching process, even when the tension application member 600 comes into contact with the portion and causes damage to a surface, the quality of the manufactured electrode plate 10 may not be affected.

The support 610 may have a predetermined length. The length of the support 610 may be smaller than the height of the punch 500. The length of the support 610 may be properly determined in consideration of a magnitude of tension to be applied to the electrode plate 10, an angle facing the sliding portion 620, a length of the sliding portion 620, and the like.

The support 610 may have a shape in which a lower end portion (or a lower end surface) of the support 610 is in surface contact with an upper end (or an upper end surface) of the sliding portion 620. A lower end surface of the support 610 may be inclined at a predetermined angle with respect to the lower surface of the second upper body 220. More specifically, the lower end surface of the support 610 may be an inclined flat surface in which an outer side of the lower end surface is closer to the second upper body 220 than an inner side of the lower end surface, that is, a side close to the punch 500. That is, a contact surface of the upper end surface of the sliding portion 620 and the lower end surface of the support 610 is inclined upwardly from a center toward an outside of a lower surface of the upper body 200. Accordingly, as the second upper body 220 descends, when the tension application member 600 comes into contact with the electrode plate 10, and a downward force is applied to the support 610, the sliding portion 620 may move toward to an outer side of the support 610, that is, toward an outer side of the electrode plate 10, to apply tension to the electrode plate 10 in the second direction

The sliding portion 620 may be slidably coupled to the support 610. An upper end surface of the sliding portion 620 may be parallel to the lower end surface of the support 610. Accordingly, as the tension application member 600 descends, when a lower end (more specifically, a contact member 622) of the sliding portion 620 comes into contact with the electrode plate 10, the sliding portion 620 may slide toward the outer side of the support 610 in the second direction while in surface contact with the support 610. Accordingly, tension may be applied to the electrode plate 10 in the second direction by the sliding portion 620 which slides toward the outer side of the support 610.

The contact member 622 may be provided on the lower end of the tension application member 600 (e.g., the sliding portion 620). The contact member 622 is a member which comes into contact with the electrode plate 10, that is, the second region 12 or the third region 13, disposed on the die 300 when the tension application member 600 descends. The contact member 622 may be coupled to the lower end of the sliding portion 620 through a method such as bonding, bolting, or fitting.

The contact member 622 may be formed of a flexible elastic material capable of preventing the electrode plate 10 from being torn when in contact with the electrode plate 10. In addition, the contact member 622 may be formed of the material capable of generating a predetermined frictional force against the electrode plate 10 such that tension is applied to the electrode plate 10 in the second direction to correspond to movement of the sliding portion 620 in the second direction. For example, the contact member 622 may be formed of rubber but is not limited thereto.

The elastic connection member 630 may connect the support 610 to the sliding portion 620. To this end, one end (upper end) of the elastic connection member 630 may be connected to the support 610, and the other end (lower end) thereof may be connected to the sliding portion 620. A length of the elastic connection member 630 may be increasable or decreasable. Accordingly, the elastic connection member 630 may prevent the sliding portion 620 from being separated from the support 610 by connecting the support 610 to the sliding portion 620. That is, as illustrated in FIG. 7A, the elastic connection member 630 may allow the support 610 and the sliding portion 620 to be connected in a vertically aligned state when the elastic connection member 630 is contracted, and the sliding portion 620, which is in surface contact with the support 610 at the lower end surfaceof the support 610, may be vertically aligned and connected to the support 610 by the elastic connection member 630 without using an adhesive. In addition, as illustrated in FIG. 7B, the elastic connection member 630 may allow the sliding portion 620 and the support 610 to be connected in a state in which the sliding portion 620 moves toward the outer side of the support 610 in the second direction when the elastic connection member 630 is elongated, thereby, even when the sliding portion 620 moves toward the outer side of the support 610, the elastic connection member 630 may be continuously connected to the support 610 even when vertically misaligned therewith.

In FIGS. 7A and 7B, it is illustrated that the upper end of the elastic connection member 630 extends to an upper end of the support 610 and the lower end of the elastic connection member 630 extends to the lower end of the sliding portion 620, but this is only exemplary. For example, the upper end of the elastic connection member 630 may extend to the middle or a lower portion of the support 610 or be coupled or bonded to a lower end of the support 610. In addition, the lower end of the elastic connection member 630 may extend to the middle or an upper portion of the elastic connection member 630 or be coupled or bonded to the upper end of the sliding portion 620.

In addition, in FIGS. 7A and 7B, only one elastic connection member 630 is disposed to pass through inner portions of the support 610 and the sliding portion 620, but the present invention is not limited thereto. For example, one or a plurality of elastic connection members 630 may be disposed to pass through the inner portions of the support 610 and the sliding portion 620 and/or to be in contact with outer surfaces thereof.

In addition, the elastic connection member 630 may function to restore the sliding portion 620 (see FIG. 7B), which is pressed in the third direction and moved toward the outer side of the support 610, to an initial state (see FIG. 7A). More specifically, the elastic connection member 630 may allow the sliding portion 620 to be restored to an original state when the tension application member 600 ascends to separate the contact member 622 from the electrode plate 10 as the upper body 200 ascends after the notching process is performed. To this end, the elastic connection member 630 may be formed of a material with an elastic restoring force, such as a spring or rubber, but is not limited thereto.

Next, a method of notching an electrode plate according to embodiments of the present invention will be described. In the method of notching an electrode plate which will be described herein, a process of notching an electrode plate may be performed using the electrode plate notching apparatus 1 described with reference to FIGS. 1 to 7B. However, the present embodiment is not limited thereto, and the process of notching an electrode plate may be performed using another type of electrode plate notching apparatus. For example, the method of notching an electrode plate according to the present embodiment may be applied to a process of removing a portion of the electrode plate using a laser instead of the punching machine.

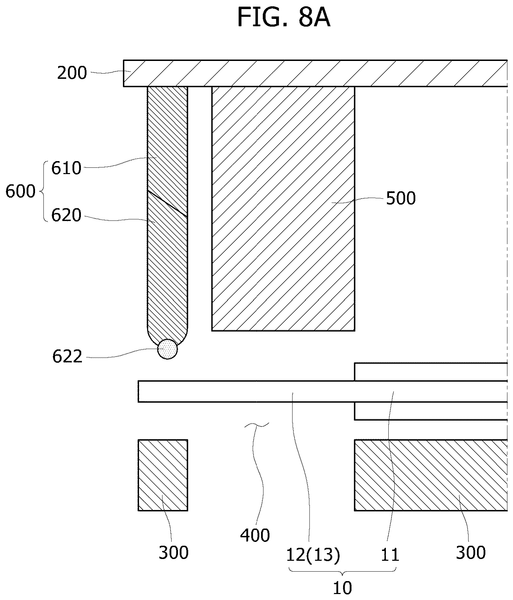

FIGS. 8A to 8D are schematic cross-sectional views illustrating the method of notching an electrode plate according to embodiments. In FIGS. 8A to 8D, only some components of the electrode plate notching apparatus 1 are illustrated, and the remaining components are omitted. In this case, the remaining components which are not illustrated in the drawings may be understood with reference to the electrode plate notching apparatus 1 described with reference to FIGS. 1 to 7B. In addition, in FIGS. 8A to 8D, a process of notching only one side portion of the electrode plate 10 in the width direction is illustrated, and it should be clear to those skilled in the art that the notching may be performed on a side portion opposite to one side portion through the same method.

Referring to FIG. 8A, the electrode plate 10 is disposed on the lower body 100 on which the die 300 is installed. Between the first roller R1 which unwinds the electrode plate 10 toward the electrode plate notching apparatus 1 and a second roller R2 which winds the electrode plate 10 on which a notching process is completed by the electrode plate notching apparatus 1, the electrode plate 10, which is tensioned in the transfer direction (first direction), may be disposed on the die 300 (see FIG. 1). In this case, the electrode plate 10 may be disposed such that a portion to be removed through the notching process in the second region 12 or the third region 13 of the electrode plate 10 is positioned between the punch 500 and the punch hole 400. That is, the method of notching an electrode plate may include an electrode plate arrangement operation of transferring an electrode plate 10 in a first direction to arrange the electrode plate 10 on an electrode plate notching apparatus (e.g., the electrode plate notching apparatus 1 described with reference to FIGS. 1 to 7B).

The upper body 200 to which the punch 500 and the tension application member 600 are fixed is disposed above the lower body 100 such that the punch 500 and the tension application member 600 are positioned to be spaced a predetermined distance from the electrode plate 10. As illustrated in FIG. 8A, a lower end portion of the tension application member 600, that is, the contact member 622, may be coupled to the sliding portion 620 to protrude downwardly further than the lower surface of the punch 500.

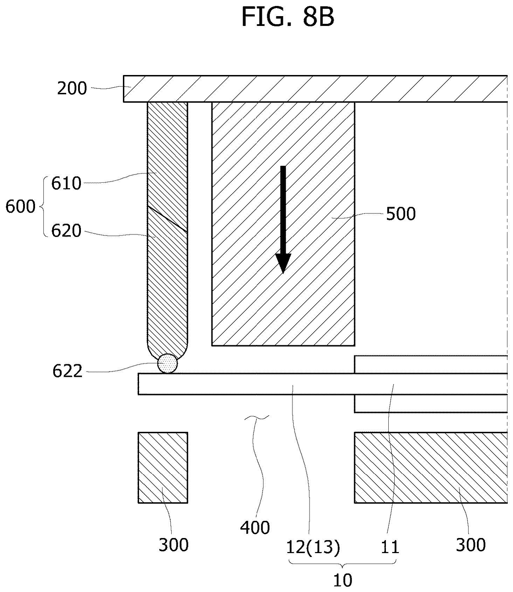

Referring to FIG. 8B, as the upper body 200 descends, the punch 500 and the tension application member 600 fixed to the upper body 200 descend therewith. As described herein, since the contact member 622 of the tension application member 600 protrudes downwardly further than the lower surface of the punch 500, the contact member 622 arrives at and comes into contact with the electrode plate 10 first before the punch 500 arrives at the electrode plate 10. For example, the contact member 622 may come into contact with a portion which corresponds to the outside of the portion on which the electrode tab is formed in the second region 12 or the third region 13 of the electrode plate 10, and is removed and discarded through the notching process. That is, the method of notching an electrode plate may include a tension application operation of applying (e.g., applying by using the electrode plate notching apparatus 1 described with reference to FIGS. 1 to 7B) tension to the electrode plate 10 in a second direction intersecting the first direction.

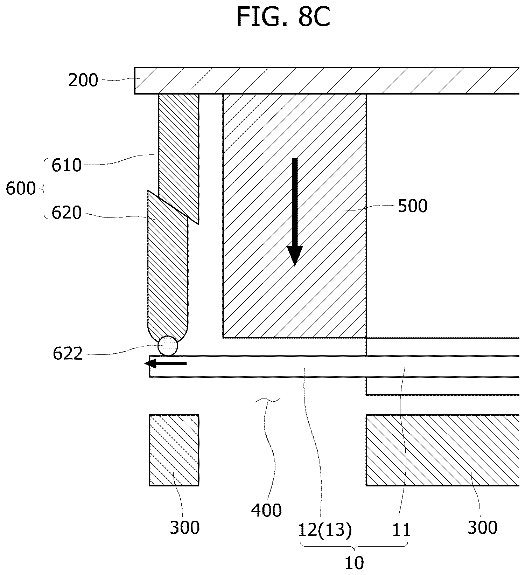

Referring to FIG. 8C, as the upper body 200 descends further, the punch 500 and the tension application member 600 fixed to the upper body 200 descend further. However, the state illustrated in FIG. 8C is a state before the punch 500 arrives at the electrode plate 10. As illustrated in FIG. 8C, in the state in which the contact member 622 of the tension application member 600 is in contact with the electrode plate 10, when the tension application member 600 descends further, the sliding portion 620 connected to the support 610 moves toward the outer side of the electrode plate 10. Accordingly, tension starts to be applied to the electrode plate 10 toward the outer side of the electrode plate 10 by the sliding portion 620. That is, the method of notching an electrode plate may include a cutting operation of cutting and removing (e.g., cutting and removing by using the electrode plate notching apparatus 1 described with reference to FIGS. 1 to 7B) a portion of a non-coating portion (e.g., the second region 12 and/or the third region 13) of the electrode plate 10 to which the tension is applied.

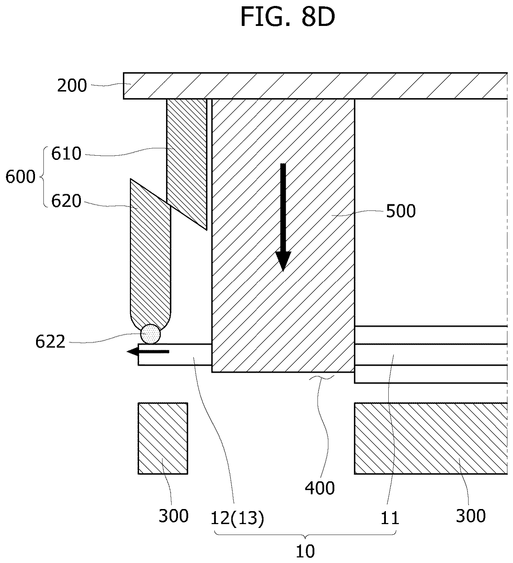

Referring to FIG. 8D, as the upper body 200 descends further, the punch 500 and the tension application member 600 fixed to the upper body 200 also descend further. Accordingly, the sliding portion 620 of the tension application member 600 moves further from the support 610 toward the outer side of the electrode plate 10, and greater tension is applied to the electrode plate 10 in the second direction. In addition, the punch 500 which descends at the same time is inserted into the punch hole 400 to cut the electrode plate 10, that is, the second region 12 or the third region 13.

Then, when the cutting of the second region 12 or the third region 13 is completed, the upper body 200 starts to ascend, and accordingly, the punch 500 and the tension application member 600 also ascend. Accordingly, the punch 500 is withdrawn from the punch hole 400 and ascends further than the electrode plate 10. In addition, while the tension application member 600 ascends, the contact member 622 is separated from the electrode plate 10, and then the sliding portion 620 moves inward and is aligned with the support 610 in a vertical direction (third direction). Then, when the upper body 200 continuously ascends to an initial level, the electrode plate notching apparatus 1 enters the state illustrated in FIG. 8A. Then, when the electrode plate 10 is transferred a predetermined distance from the first roller R1 toward the second roller R2, another portion of the electrode plate 10 on which the notching process needs to be performed is disposed on the die 300 of the electrode plate notching apparatus 1.

According to embodiments of the present invention, since a portion of an electrode plate is removed in a state in which tension is applied in a width direction of the electrode plate intersecting a transfer direction of the electrode plate, generation of threads or burrs can be suppressed or prevented.

However, effects which can be achieved through the present invention are not limited to the herein-described effects, and other effects which are not described herein will be clearly understood by those skilled in the art from the herein description of the present invention.

Although the present invention has been described with reference to embodiments illustrated in the accompanying drawings, these are merely exemplary. It will be understood by those skilled in the art that various modifications and other equivalent embodiments are possible from the embodiments of the present invention.

Therefore, the scope of the present invention should be defined by the appended claims.

## Claims

1. An electrode plate notching apparatus (1) comprising:
a lower body (100) which supports an electrode plate (10) transferred in a first direction;
a die (300) installed on the lower body (100) to face a non-coating portion of the electrode plate (10) and including a punch hole;
an upper body (200) installed above the lower body (100) to be movable upwardly and downwardly;
a punch (500) installed on the upper body (200) to ascend and descend in conjunction with ascent and descent of the upper body (200) and inserted into the punch hole (400) as the upper body (200) descends; and
a tension application member (600) which applies tension to the electrode plate (10) in a second direction intersecting the first direction before the punch (500) is inserted into the punch hole (400).

2. The electrode plate notching apparatus (1) according to claim 1, wherein the tension application member (600) is installed on the upper body (200) to ascend and descend in conjunction with the ascent and the descent of the upper body (200).

3. The electrode plate notching apparatus (1) according to claim 1 or 2, wherein the tension application member (600) is installed further outwardly than the punch (500) in the second direction.

4. The electrode plate notching apparatus (1) according to any of the preceding claims, wherein the tension application member (600) is installed on the upper body (200) to protrude downwardly further than a lower surface of the punch (500).

5. The electrode plate notching apparatus (1) according to any of the preceding claims, wherein the tension application member (600) is formed such that a lower end portion of the tension application member (600) moves outwardly in the second direction when a force is applied to the tension application member (600) downwardly as the upper body descends.

6. The electrode plate notching apparatus (1) of claim 5, wherein the tension application member (600) includes:
a support (610) of which an upper end is fixed to the upper body (200);
a sliding portion (620) of which an upper end surface is disposed in surface contact with a lower end surface of the support (610) such that the sliding portion (620) moves toward an outer side of the support (610) in the second direction when the support (610) descends after a lower end of the sliding portion (620) is in contact with the electrode plate (10); and
an elastic connection member (630) of which an upper end is fixed to the support (610), a lower end is fixed to the sliding portion (620) to connect the support (610) to the sliding portion (620), and a length is increasable or decreasable.

7. The electrode plate notching apparatus (1) according to claim 6, wherein a contact surface of the upper end surface of the sliding portion (620) and the lower end surface of the support (610) is inclined upwardly from a center toward an outside of a lower surface of the upper body (200).

8. The electrode plate notching apparatus (1) according to claim 6 or 7, wherein the elastic connection member (630) is installed to allow the support (610) and the sliding portion (620) to be connected in a vertically aligned state when the elastic connection member (630) is contracted and allow the sliding portion (620) and the support (610) to be connected in a state in which the sliding portion (620) moves toward the outer side of the support (610) in the second direction when the elastic connection member (630) is elongated.

9. The electrode plate notching apparatus (1) according to any of the preceding claims, wherein a contact member (622) is provided on a lower end of the tension application member (600).

10. The electrode plate notching apparatus (1) according to claim 9, wherein the contact member (622) is formed of rubber.

11. An electrode plate notching apparatus (10) comprising:
a lower body (100) which supports an electrode plate (10) which is transferred in a first direction and includes non-coating portions at both edges in a second direction intersecting the first direction;
a pair of dies (300) installed on the lower body (100) to be spaced apart from each other in the second direction to face the non-coating portions and each including a punch hole (400);
an upper body (200) installed above the lower body (100) to be moveable upwardly and downwardly;
a pair of punches (500) installed on the upper body (200) to be spaced apart from each other in the second direction to ascend and descend in conjunction with ascent and descent of the upper body (200) and inserted into the pair of punch holes (400) as the upper body (200) descends; and
a pair of tension application members (600) installed on the upper body (200) to be spaced apart from each other in the second direction to ascend and descend in conjunction with the ascent and the descent of the upper body (200) and apply tension to the electrode plate (10) in the second direction before the punches (500) are inserted into the punch holes (400).

12. A method of notching an electrode plate (10), comprising:
an electrode plate arrangement operation of transferring an electrode plate (10) in a first direction to arrange the electrode plate (10) on an electrode plate notching apparatus (1);
a tension application operation of applying tension to the electrode plate (10) in a second direction intersecting the first direction; and
a cutting operation of cutting and removing a portion of a non-coating portion of the electrode plate (10) to which the tension is applied.

13. The method of claim 12, wherein the electrode plate notching apparatus (1) includes the electrode plate notching apparatus (1) according to any of the claims 1 to 11.
